# EUROPEAN PATENT APPLICATION

(11) **EP 4 848 923 A1**
(43) Date of publication of application: **02.12.2026**
(21) Application number: 25883854.9
(22) Date of filing: 17.01.2025
(51) Int. Cl.: H10B 12/00

(54) **SEMICONDUCTOR STRUCTURE, MANUFACTURING METHOD THEREFOR, AND ELECTRONIC DEVICE**

(30) Priority: 31.10.2024 CN 202411545203
(71) Applicant: CXMT Corporation, Hefei, Anhui 230601 (CN)
(72) Inventor: FENG, Daohuan, Hefei, Anhui 230601 (CN); JIANG, Yi, Hefei, Anhui 230601 (CN); XIAO, Deyuan, Hefei, Anhui 230601 (CN)
(74) Representative: Gulde & Partner
(86) International application number: PCT/CN2025/072896
(87) International publication number: WO 2026/091317

(57) **Abstract**

A semiconductor structure and a method for manufacturing the same, and an electronic device are provided. The semiconductor structure includes: an active pillar extending along a vertical direction; a word line extending along a first horizontal direction and coupled to the active pillar to form a transistor; and a bit line extending along a second horizontal direction and coupled to the active pillar. The second horizontal direction intersects with the first horizontal direction. The word line includes a first gate part and a second gate part that cover a side wall of the active pillar and are connected to each other, the first gate part is located on at least one side of the active pillar in the first horizontal direction, the second gate part is located on at least one side of the active pillar in the second horizontal direction, and an average size of the first gate part in the vertical direction is different from an average size of the second gate part in the vertical direction. The semiconductor structure can reduce the leakage current caused by gate induced drain leakage, thereby improving the device performance.

## Description

The present disclosure claims priority to Chinese Patent Application No. 202411545203.9, filed with China National Intellectual Property Administration on October 31, 2024 and entitled "SEMICONDUCTOR STRUCTURE AND METHOD FOR MANUFACTURING SAME, AND ELECTRONIC DEVICE", the content of which is incorporated herein by reference in its entirety.

### TECHNICAL FIELD

Embodiments of the present disclosure relate to the technical field of semiconductors, and in particular to a semiconductor structure and a method for manufacturing the same, and an electronic device.

### BACKGROUND

A dynamic random access memory (dynamic random access memory, DRAM) is a type of semiconductor memory. Compared with a static memory, the DRAM has the advantages of a simpler structure, a lower manufacturing cost, and a higher storage density. With the development of technology, the application of the DRAM is becoming increasingly widespread. The DRAM includes a plurality of memory cells, and each memory cell includes a transistor and a capacitor coupled to the transistor. One of a source and a drain of the transistor is connected to a bit line, the other of the source and the drain of the transistor is connected to the capacitor, and a gate of the transistor is connected to a word line. The transistor writes data information into the capacitor or reads data information from the capacitor through the bit line under control of the word line.

With the development of semiconductor technologies, an architecture solution of changing a planar transistor or a buried transistor in a DRAM into a vertical transistor (at least a part of a channel of the vertical transistor extends along a vertical direction) has been proposed. In this architecture, an active pillar extending vertically is formed on a substrate, and a gate is formed on a side surface of the active pillar.

### SUMMARY

According to a first aspect of embodiments of the present disclosure, a semiconductor structure is provided. The semiconductor structure includes: an active pillar extending along a vertical direction; a word line extending along a first horizontal direction and coupled to the active pillar to form a transistor; and a bit line extending along a second horizontal direction and coupled to the active pillar. The second horizontal direction intersects with the first horizontal direction. The word line includes a first gate part and a second gate part that cover a side wall of the active pillar and are connected to each other, the first gate part is located on at least one side of the active pillar in the first horizontal direction, the second gate part is located on at least one side of the active pillar in the second horizontal direction, and an average size of the first gate part in the vertical direction is different from an average size of the second gate part in the vertical direction.

In some embodiments, the active pillar includes a first source/drain region, a channel region, and a second source/drain region sequentially arranged in the vertical direction, and the average size of a certain one of the first gate part and the second gate part in the vertical direction is less than a channel length of the channel region in the vertical direction.

In some embodiments, a maximum size of the certain one of the first gate part and the second gate part in the vertical direction is less than the channel length of the channel region in the vertical direction.

In some embodiments, the average size of the first gate part in the vertical direction is less than the average size of the second gate part in the vertical direction.

In some embodiments, the word line includes two first gate parts located on two opposite sides of the active pillar in the first horizontal direction and two second gate parts located on two opposite sides of the active pillar in the second horizontal direction.

In some embodiments, an average size of the first gate part in a horizontal direction perpendicular to the first horizontal direction is less than an average size of the second gate part in a horizontal direction perpendicular to the second horizontal direction.

In some embodiments, a top surface of the first gate part is lower than or flush with a top surface of the second gate part.

In some embodiments, the word line includes one first gate part located on one side of the active pillar in the first horizontal direction and two second gate parts located on two opposite sides of the active pillar in the second horizontal direction.

In some embodiments, an average size of the first gate part in a horizontal direction perpendicular to the first horizontal direction is greater than an average size of the second gate part in a horizontal direction perpendicular to the second horizontal direction, and a top surface of the first gate part is lower than a top surface of the second gate part.

In some embodiments, an average size of the first gate part in a horizontal direction perpendicular to the first horizontal direction is equal to an average size of the second gate part in a horizontal direction perpendicular to the second horizontal direction, and a top surface of the first gate part is flush with a top surface of the second gate part.

In some embodiments, the average size of the first gate part in the vertical direction is greater than the average size of the second gate part in the vertical direction.

In some embodiments, the word line includes two first gate parts located on two opposite sides of the active pillar in the first horizontal direction and two second gate parts located on two opposite sides of the active pillar in the second horizontal direction.

In some embodiments, the word line includes one first gate part located on one side of the active pillar in the first horizontal direction and two second gate parts located on two opposite sides of the active pillar in the second horizontal direction.

In some embodiments, an average size of the first gate part in a horizontal direction perpendicular to the first horizontal direction is less than an average size of the second gate part in a horizontal direction perpendicular to the second horizontal direction.

In some embodiments, a bottom surface of the first gate part is lower than or flush with a bottom surface of the second gate part.

In some embodiments, the semiconductor structure further includes a data storage element coupled to the transistor.

According to a second aspect of the embodiments of the present disclosure, a method for manufacturing a semiconductor structure is provided. The method includes: providing a semiconductor substrate; etching the semiconductor substrate to form an active pillar extending along a vertical direction; forming a word line, where the word line extends along a first horizontal direction and is coupled to the active pillar; and forming a bit line, where the bit line extends along a second horizontal direction and is coupled to the active pillar, and the second horizontal direction intersects with the first horizontal direction. The word line includes a first gate part and a second gate part that cover a side wall of the active pillar and are connected to each other, the first gate part is located on at least one side of the active pillar in the first horizontal direction, the second gate part is located on at least one side of the active pillar in the second horizontal direction, and an average size of the first gate part in the vertical direction is different from an average size of the second gate part in the vertical direction.

According to a third aspect of the embodiments of the present disclosure, an electronic device is provided. The electronic device includes a processor and the memory according to any one of the embodiments of the present disclosure. The memory is coupled to the processor.

In the semiconductor structure according to the embodiments of the present disclosure, the average size of the first gate part in the vertical direction is different from the average size of the second gate part in the vertical direction, which helps to reduce the lateral overlapping area between one of the first gate part and the second gate part and a source/drain region in the active pillar, thereby reducing the leakage current caused by gate induced drain leakage (gate induced drain leakage, GIDL), and further improving the device performance.

### BRIEF DESCRIPTION OF DRAWINGS

FIG. 1A is a schematic diagram of a partial planar structure of a semiconductor structure according to some embodiments of the present disclosure;
FIG. 1B is a schematic diagram of a partial cross-sectional structure taken along line A1-A2 in FIG. 1A according to some embodiments of the present disclosure;
FIG. 1C is a schematic diagram of a partial cross-sectional structure taken along line B1-B2 in FIG. 1A according to some embodiments of the present disclosure;
FIG. 1D is a schematic structural diagram of a first gate part and a second gate part surrounding the same active pillar according to some embodiments of the present disclosure;
FIG. 1E is another schematic structural diagram of a first gate part and a second gate part surrounding the same active pillar according to some embodiments of the present disclosure;
FIG. 2A is another schematic diagram of a partial cross-sectional structure taken along line A1-A2 in FIG. 1A according to some embodiments of the present disclosure;
FIG. 2B is a schematic diagram of a partial cross-sectional structure taken along line B1-B2 in FIG. 1A according to some embodiments of the present disclosure;
FIG. 2C is yet another schematic structural diagram of a first gate part and a second gate part surrounding the same active pillar according to some embodiments of the present disclosure;
FIG. 2D is still another schematic structural diagram of a first gate part and a second gate part surrounding the same active pillar according to some embodiments of the present disclosure;
FIG. 3A is a schematic diagram of a partial planar structure of a semiconductor structure according to some other embodiments of the present disclosure;
FIG. 3B is a schematic diagram of a partial cross-sectional structure taken along line A1-A2 in FIG. 3A according to some embodiments of the present disclosure;
FIG. 3C is a schematic diagram of a partial cross-sectional structure taken along line B1-B2 in FIG. 3A according to some embodiments of the present disclosure;
FIG. 3D is a schematic structural diagram of a first gate part and a second gate part surrounding the same active pillar according to some embodiments of the present disclosure;
FIG. 3E is another schematic structural diagram of a first gate part and a second gate part surrounding the same active pillar according to some embodiments of the present disclosure;
FIG. 4A is another schematic diagram of a partial cross-sectional structure taken along line A1-A2 in FIG. 3A according to some embodiments of the present disclosure;
FIG. 4B is a schematic diagram of a partial cross-sectional structure taken along line B1-B2 in FIG. 3A according to some embodiments of the present disclosure;
FIG. 4C is yet another schematic structural diagram of a first gate part and a second gate part surrounding the same active pillar according to some embodiments of the present disclosure;
FIG. 4D is still another schematic structural diagram of a first gate part and a second gate part surrounding the same active pillar according to some embodiments of the present disclosure;
FIGS. 5A to 5D are schematic cross-sectional diagrams of some phases of a method for manufacturing a semiconductor structure according to some embodiments of the present disclosure;
FIGS. 6A to 6D are schematic cross-sectional diagrams of some phases of a method for manufacturing a semiconductor structure according to some other embodiments of the present disclosure;
FIGS. 7A to 7E are schematic cross-sectional diagrams of some phases of a method for manufacturing a semiconductor structure according to yet other embodiments of the present disclosure;
FIGS. 8A to 8D are schematic cross-sectional diagrams of some phases of a method for manufacturing a semiconductor structure according to still other embodiments of the present disclosure; and
FIG. 9 is a schematic block diagram of a structure of an electronic device according to some embodiments of the present disclosure.

### DESCRIPTION OF EMBODIMENTS

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided so that the present disclosure will be more thoroughly understood and the scope of the present disclosure will be fully conveyed to those skilled in the art.

The present disclosure is more specifically described in the following paragraphs with reference to the drawings by way of example. The advantages and features of the present disclosure will become apparent from the following description and claims. It should be noted that the drawings are all in a very simplified form and not to a precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between the top surface and the bottom surface of a continuous structure, or a layer may be located between any pair of horizontal planes at the top surface and the bottom surface of the continuous structure. A layer may extend horizontally, perpendicularly, and/or along inclined surfaces. A layer may include a plurality of sub-layers.

In the embodiments of the present disclosure, the term "couple" means that two (or more) conductive structures are operatively connected to each other, and may include, but are not limited to, the following cases according to actual needs: 1) the two conductive structures are directly electrically connected; 2) the two conductive structures are indirectly electrically connected (through other conductive structures); 3) one of the two conductive structures may control an electrical property of the other of the two conductive structures in response to an electrical signal although no electrical connection is made between the two conductive structures (e.g., an insulating layer is provided therebetween), e.g., a gate (or word line) is coupled to an active region (or channel region).

It should be noted that unless conflicting, the technical solutions and the technical features described in the embodiments of the present disclosure may be arbitrarily combined.

At least some embodiments of the present disclosure provide a semiconductor structure. The semiconductor structure includes: an active pillar extending along a vertical direction; a word line extending along a first horizontal direction and coupled to the active pillar to form a transistor; and a bit line extending along a second horizontal direction and coupled to the active pillar. The second horizontal direction intersects with the first horizontal direction. The word line includes a first gate part and a second gate part covering a side wall of the active pillar and connected to each other, the first gate part is located on at least one side of the active pillar in the first horizontal direction, the second gate part is located on at least one side of the active pillar in the second horizontal direction, and the average size of the first gate part in the vertical direction is different from the average size of the second gate part in the vertical direction.

In the semiconductor structure according to the embodiments of the present disclosure, the average size of the first gate part in the vertical direction is different from the average size of the second gate part in the vertical direction, which helps to reduce the lateral overlapping area between one of the first gate part and the second gate part and a source/drain region in the active pillar, thereby reducing the leakage current caused by gate induced drain leakage (gate induced drain leakage, GIDL), and further improving the device performance.

The semiconductor structure according to the embodiments of the present disclosure is described in detail below with reference to the drawings.

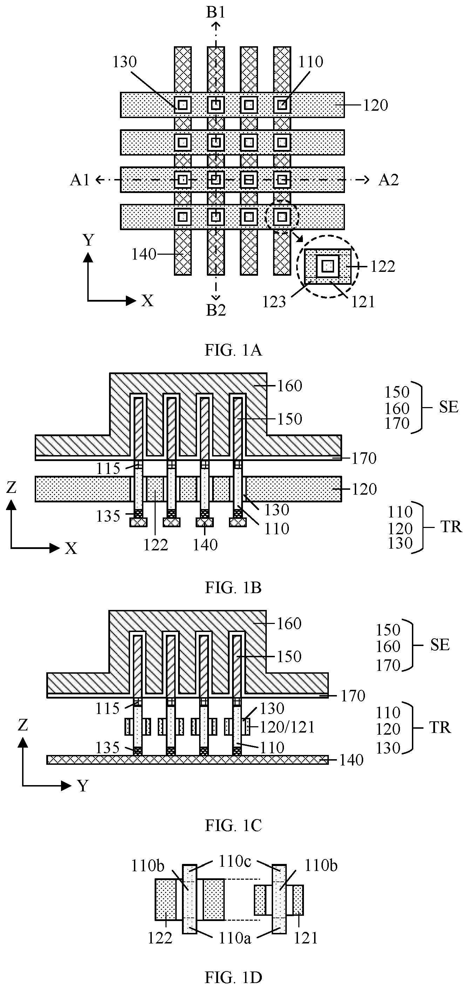

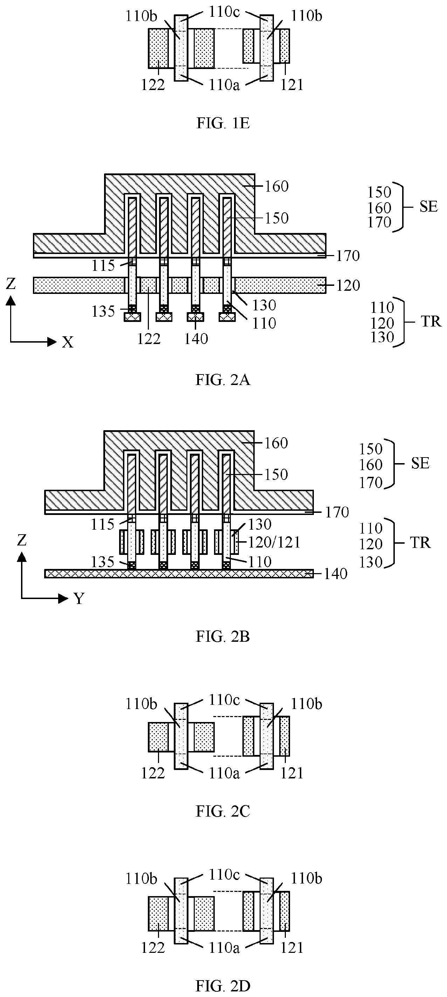

FIG. 1A is a schematic diagram of a partial planar structure of a semiconductor structure according to some embodiments of the present disclosure; FIG. 1B is a schematic diagram of a partial cross-sectional structure taken along line A1-A2 in FIG. 1A according to some embodiments of the present disclosure; FIG. 1C is a schematic diagram of a partial cross-sectional structure taken along line B1-B2 in FIG. 1A according to some embodiments of the present disclosure; FIG. 1D is a schematic structural diagram of a first gate part and a second gate part surrounding the same active pillar according to some embodiments of the present disclosure; FIG. 1E is another schematic structural diagram of a first gate part and a second gate part surrounding the same active pillar according to some embodiments of the present disclosure.

As shown in FIGS. 1A to 1E, the semiconductor structure includes an active pillar 110, a word line 120, and a bit line 140. The active pillar 110 extends along a vertical direction Z; the word line 120 extends along a first horizontal direction X and is coupled to the active pillar 120 to form a transistor TR; the bit line 140 extends along a second horizontal direction Y and is coupled to the active pillar 120. The second horizontal direction Y intersects with the first horizontal direction X. For example, the second horizontal direction Y is perpendicular to the first horizontal direction X. The word line 120 includes a first gate part 121 and a second gate part 122 that cover a side wall of the active pillar 110 and are connected to each other. The first gate part 121 is located on at least one side of the active pillar 110 in the first horizontal direction X, the second gate part 122 is located on at least one side of the active pillar in the second horizontal direction Y, and the average size of the first gate part 121 in the vertical direction Z is different from the average size of the second gate part 122 in the vertical direction Z. In the present disclosure, the numerical value of the "average size" of a certain component in a certain direction may be obtained by integrating and summing the sizes of the component in the direction and then taking an average value.

For example, in some examples, as shown in FIGS. 1A to 1E, the word line 120 includes two first gate parts 121 located on two opposite sides of the active pillar 110 in the first horizontal direction X and two second gate parts 122 located on two opposite sides of the active pillar 110 in the second horizontal direction Y. For example, as shown in FIG. 1A, the first gate part 121 and the second gate part 123 are connected by a gate connecting part 123. Of course, in some examples, the gate connecting part 123 may be a part of the first gate part 121 or a part of the second gate part 123.

For example, as shown in FIGS. 1D and 1E, the active pillar 110 include a first source/drain region 110a, a channel region 110b, and a second source/drain region 110c sequentially arranged in the vertical direction Z, and the average size of one of the first gate part 121 and the second gate part 122 in the vertical direction Z is less than the channel length of the channel region 110b in the vertical direction Z. For example, the maximum size of one of the first gate part 121 and the second gate part 122 in the vertical direction Z is less than the channel length of the channel region 110b in the vertical direction Z.

For example, in some examples, as shown in FIGS. 1D and 1E, the average size (or the maximum size) of the first gate part 121 in the vertical direction Z is less than the average size (or the maximum size) of the second gate part 122 in the vertical direction Z. For example, as shown in FIGS. 1D and 1E, the average size of the first gate part 121 in the vertical direction Z is less than the channel length of the channel region 110b in the vertical direction Z, and the average size of the second gate part 122 in the vertical direction Z is greater than the channel length of the channel region 110b in the vertical direction Z. For example, if the average size of the gate connecting part 123 in the vertical direction Z is closer to the average size of the first gate part 121 in the vertical direction Z, the gate connecting part 123 may serve as a part of the first gate part 121; conversely, if the average size of the gate connecting part 123 in the vertical direction Z is closer to the average size of the second gate part 122 in the vertical direction Z, the gate connecting part 123 may serve as a part of the second gate part 122.

For example, in some examples, as shown in FIGS. 1D and 1E, at least a part of the channel region 110b is located outside a region defined by planes where the top surface and the bottom surface of the first gate part 121 are located, and the channel region 110b, as a whole, is located within the region defined by the planes where the top surface and the bottom surface of the first gate part 121 are located. For example, as shown in FIG. 1D, the first gate part 121 does not laterally overlap either of the first source/drain region 110a and the second source/drain region 110c; or, as shown in FIG. 1E, the first gate part 121 laterally overlaps the second source/drain region 110c, but does not laterally overlap the first source/drain region 110a. In contrast, as shown in FIGS. 1D and 1E, the second gate part 122 laterally overlaps both the first source/drain region 110a and the second source/drain region 110c.

For example, in some examples, as shown in FIG. 1A, the average size of the first gate part 121 in a horizontal direction perpendicular to the first horizontal direction X is less than the average size of the second gate part in a horizontal direction perpendicular to the second horizontal direction Y. For example, when the second horizontal direction Y is perpendicular to the first horizontal direction X, the horizontal direction perpendicular to the first horizontal direction X is the second horizontal direction Y, and the horizontal direction perpendicular to the second horizontal direction Y is the first horizontal direction X.

For example, in some examples, as shown in FIG. 1D, the top surface of the first gate part 121 is lower than the top surface of the second gate part 122. For example, in some other examples, as shown in FIG. 1E, the top surface of the first gate part 121 is flush with the top surface of the second gate part 122.

For example, as shown in FIGS. 1A to 1E, the semiconductor structure may further include a gate dielectric layer 130 disposed between the active pillar 110 and the word line 120. For example, the first gate part 121 and the second gate part 122 both cover the gate dielectric layer 130, and the gate dielectric layer 130 may be one of the components of the transistor TR.

For example, as shown in FIGS. 1B and 1C, the semiconductor structure may further include a data storage element SE coupled to the transistor TR. The embodiments of the present disclosure illustrate the data storage element SE by taking a capacitor as an example, but this should not be construed as limiting the present disclosure. For example, in some examples, as shown in FIGS. 1B and 1C, the capacitor SE may include a first electrode 150, a second electrode 160, and a capacitor dielectric layer 170 disposed between the first electrode 150 and the second electrode 160. For example, the second electrodes 160 of a plurality of capacitors SE may be formed as a common electrode 160. It can be understood that the data storage element SE may not be limited to a capacitor. For example, the data storage element SE may also be a FeRAM storage element (such as a ferroelectric capacitor), a PCM storage element, an MRAM storage element, etc. That is, the semiconductor structure according to the embodiments of the present disclosure may be formed as a DRAM, a FeRAM (ferroelectric random access memory), a PCM (phase change memory), an MRAM (magnetic random access memory), etc.

For example, in some examples, as shown in FIGS. 1B and 1C, the first electrode 150 may be coupled to a corresponding active pillar 110 through a contact pad 115; the bit line 140 may be coupled to a corresponding active pillar 110 through a bit line contact plug 135. For example, in some other examples, at least one of the contact pad 115 and the bit line contact plug 135 may be omitted.

For example, the material of the active pillar 110 may include any suitable semiconductor material, such as silicon, germanium, or gallium arsenide. For example, the materials of the gate dielectric layer 130 and the capacitor dielectric layer 170 include any suitable dielectric material, such as silicon dioxide, silicon nitride, a high-K dielectric material, or any combination thereof. For example, the high-K dielectric material may include, but is not limited to, hafnium oxide (HfO₂), zirconium oxide (ZrO₂), and the like. For example, for example, the material of each of the word line 120, the bit line 140, the contact pad 115, the bit line contact plug 135, the first electrode 150, and the second electrode 160 may include any suitable conductive material, such as titanium nitride (TiN), tantalum nitride (TaN), tungsten, metal silicide, doped polycrystalline silicon, or any combination thereof.

FIG. 2A is another schematic diagram of a partial cross-sectional structure taken along line A1-A2 in FIG. 1A according to some embodiments of the present disclosure; FIG. 2B is a schematic diagram of a partial cross-sectional structure taken along line B1-B2 in FIG. 1A according to some embodiments of the present disclosure; FIG. 2C is yet another schematic structural diagram of a first gate part and a second gate part surrounding the same active pillar according to some embodiments of the present disclosure; FIG. 2D is still another schematic structural diagram of a first gate part and a second gate part surrounding the same active pillar according to some embodiments of the present disclosure. The main difference between the semiconductor structure in the embodiments shown in FIGS. 2A to 2D and the semiconductor structure in the embodiments shown in FIGS. 1B to 1E is that: as shown in FIGS. 2A to 2D, the average size of the first gate part 121 in the vertical direction Z is greater than the average size of the second gate part 122 in the vertical direction Z. The following mainly describes differences and some sameness or similarities between the embodiments shown in FIGS. 2A to 2D and the embodiments shown in FIGS. 1B to 1E. For sameness or similarities that are not described, reference can be made to the related description of the embodiments shown in FIGS. 1B to 1E.

For example, in some examples, as shown in FIGS. 1A and 2A to 2D, the word line 120 includes two first gate parts 121 located on two opposite sides of the active pillar 110 in the first horizontal direction X and two second gate parts 122 located on two opposite sides of the active pillar 110 in the second horizontal direction Y.

For example, in some examples, as shown in FIGS. 2C and 2D, the average size of the first gate part 121 in a horizontal direction perpendicular to the first horizontal direction X is less than the average size of the second gate part in a horizontal direction perpendicular to the second horizontal direction Y. For example, when the second horizontal direction Y is perpendicular to the first horizontal direction X, the horizontal direction perpendicular to the first horizontal direction X is the second horizontal direction Y, and the horizontal direction perpendicular to the second horizontal direction Y is the first horizontal direction X.

For example, in some examples, as shown in FIG. 2C, the bottom surface of the first gate part 121 is lower than the bottom surface of the second gate part 122. For example, in some other examples, as shown in FIG. 2D, the bottom surface of the first gate part 121 is flush with the bottom surface of the second gate part 122.

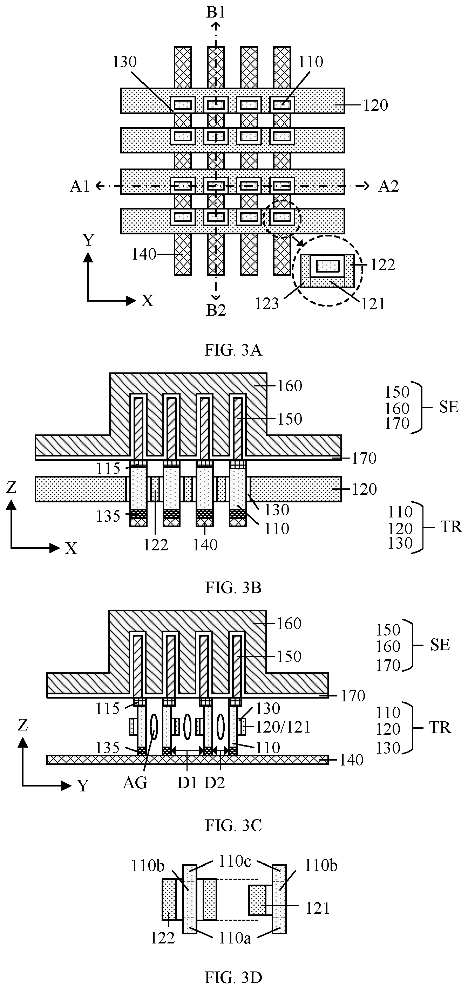

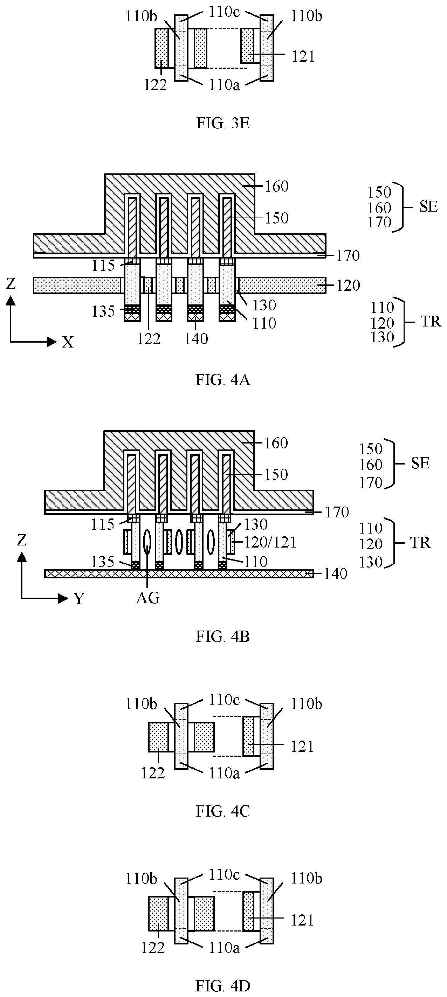

FIG. 3A is a schematic diagram of a partial planar structure of a semiconductor structure according to some other embodiments of the present disclosure; FIG. 3B is a schematic diagram of a partial cross-sectional structure taken along line A1-A2 in FIG. 3A according to some embodiments of the present disclosure; FIG. 3C is a schematic diagram of a partial cross-sectional structure taken along line B1-B2 in FIG. 3A according to some embodiments of the present disclosure; FIG. 3D is a schematic structural diagram of a first gate part and a second gate part surrounding the same active pillar according to some embodiments of the present disclosure; FIG. 3E is another schematic structural diagram of a first gate part and a second gate part surrounding the same active pillar according to some embodiments of the present disclosure. The main difference between the semiconductor structure in the embodiments shown in FIGS. 3A to 3E and the semiconductor structure in the embodiments shown in FIGS. 1A to 1E is that: as shown in FIGS. 3A to 3E, the word line 120 includes one first gate part 121 located on one side of the active pillar 110 in the first horizontal direction X and two second gate parts 122 located on two opposite sides of the active pillar 110 in the second horizontal direction Y. That is, in the embodiments shown in FIGS. 1A to 1E, the transistor TR is of a gate-all-around structure; while in the embodiments shown in FIGS. 3A to 3E, the transistor TR is of a three-sided gate-all-around structure. The following mainly describes differences and some sameness or similarities between the embodiments shown in FIGS. 3A to 3E and the embodiments shown in FIGS. 1A to 1E. For sameness or similarities that are not described, reference can be made to the related description of the embodiments shown in FIGS. 1A to 1E.

For example, in some examples, as shown in FIGS. 3A and 3C, a plurality of active pillars 110 are arranged alternatively with a first spacing D1 and a second spacing D2 in the second horizontal direction Y, where the first spacing D1 is greater than the second spacing D2.

For example, in some examples, as shown in FIGS. 3A to 3E, the average size (or the maximum size) of the first gate part 121 in the vertical direction Z is less than the average size (or the maximum size) of the second gate part 122 in the vertical direction Z.

For example, in some examples, as shown in FIG. 3D, the average size of the first gate part 121 in a horizontal direction perpendicular to the first horizontal direction X is greater than the average size of the second gate part in a horizontal direction perpendicular to the second horizontal direction Y, and the top surface of the first gate part 121 is lower than the top surface of the second gate part 122. For example, in some other examples, as shown in FIG. 3E, the average size of the first gate part 121 in a horizontal direction perpendicular to the first horizontal direction X is equal to the average size of the second gate part in a horizontal direction perpendicular to the second horizontal direction Y, and the top surface of the first gate part 121 is flush with the top surface of the second gate part 122.

For example, in some examples, as shown in FIG. 3C, the semiconductor structure may further include an air gap AG, and the air gap AG is located between adjacent transistors TR in the second horizontal direction Y. The air gap AG can reduce the coupling effect between adjacent transistors TR (e.g., the coupling effect between adjacent word lines 120 or the coupling effect between adjacent active pillars 110).

It should be noted that, in order to save the area and optimize the layout, the planar shape of the active pillar 110 in the embodiments shown in FIGS. 3A to 3E is different from the planar shape of the active pillar 110 in the embodiments shown in FIGS. 1A to 1E. It can be understood that the planar shape of the active pillar 110 does not substantially affect the implementation of the technical solutions, and therefore, the planar shape of the active pillar 110 is not limited in the embodiments of the present disclosure.

FIG. 4A is another schematic diagram of a partial cross-sectional structure taken along line A1-A2 in FIG. 3A according to some embodiments of the present disclosure; FIG. 4B is a schematic diagram of a partial cross-sectional structure taken along line B1-B2 in FIG. 3A according to some embodiments of the present disclosure; FIG. 4C is yet another schematic structural diagram of a first gate part and a second gate part surrounding the same active pillar according to some embodiments of the present disclosure; FIG. 4D is still another schematic structural diagram of a first gate part and a second gate part surrounding the same active pillar according to some embodiments of the present disclosure. The main difference between the semiconductor structure in the embodiments shown in FIGS. 4A to 4D and the semiconductor structure in the embodiments shown in FIGS. 3B to 3E is that: as shown in FIGS. 4A to 4D, the average size of the first gate part 121 in the vertical direction Z is greater than the average size of the second gate part 122 in the vertical direction Z. The following mainly describes differences and some sameness or similarities between the embodiments shown in FIGS. 4A to 4D and the embodiments shown in FIGS. 3B to 3E. For sameness or similarities that are not described, reference can be made to the related description in the foregoing embodiments.

For example, in some examples, as shown in FIGS. 3A and 4A to 4D, the word line 120 includes one first gate part 121 located on one side of the active pillar 110 in the first horizontal direction X and two second gate parts 122 located on two opposite sides of the active pillar 110 in the second horizontal direction Y.

For example, in some examples, as shown in FIGS. 4C and 4D, the average size of the first gate part 121 in a horizontal direction perpendicular to the first horizontal direction X is less than the average size of the second gate part in a horizontal direction perpendicular to the second horizontal direction Y. For example, when the second horizontal direction Y is perpendicular to the first horizontal direction X, the horizontal direction perpendicular to the first horizontal direction X is the second horizontal direction Y, and the horizontal direction perpendicular to the second horizontal direction Y is the first horizontal direction X.

For example, in some examples, as shown in FIG. 4C, the bottom surface of the first gate part 121 is lower than the bottom surface of the second gate part 122. For example, in some other examples, as shown in FIG. 4D, the bottom surface of the first gate part 121 is flush with the bottom surface of the second gate part 122.

In the semiconductor structure according to the embodiments of the present disclosure, the average size of the first gate part in the vertical direction is different from the average size of the second gate part in the vertical direction, which helps to reduce the lateral overlapping area between one of the first gate part and the second gate part and a source/drain region in the active pillar, thereby reducing the leakage current caused by GIDL, and further improving the device performance.

At least some embodiments of the present disclosure further provide a method for manufacturing a semiconductor structure. The method for manufacturing a semiconductor structure may be used for manufacturing the semiconductor structure according to the foregoing embodiments. For example, the method for manufacturing a semiconductor structure may include the following steps S100 to S400.

In S100, a semiconductor substrate is provided.

In S200, the semiconductor substrate is etched to form an active pillar extending along a vertical direction.

In S300, a word line is formed, where the word line extends along a first horizontal direction and is coupled to the active pillar, the word line includes a first gate part and a second gate part that cover a side wall of the active pillar and are connected to each other, the first gate part is located on at least one side of the active pillar in the first horizontal direction, the second gate part is located on at least one side of the active pillar in a second horizontal direction, and the average size of the first gate part in the vertical direction is different from the average size of the second gate part in the vertical direction.

In S400, a bit line is formed, where the bit line extends along the second horizontal direction and is coupled to the active pillar, and the second horizontal direction intersects with the first horizontal direction.

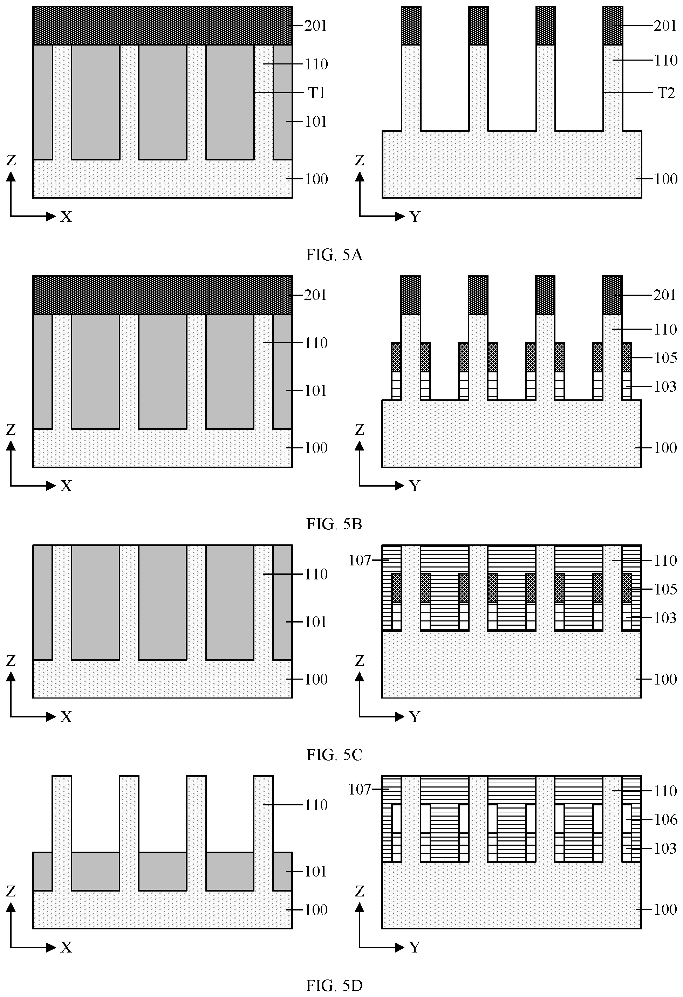

FIGS. 5A to 5D are schematic cross-sectional diagrams of some phases of a method for manufacturing a semiconductor structure according to some embodiments of the present disclosure. In FIGS. 5A to 5D, the left sub-figure corresponds to a cross-section taken along line A1-A2 in FIG. 1A, and the right sub-figure corresponds to a cross-section taken along line B1-B2 in FIG. 1A. Steps S200 and S300 in the method for manufacturing a semiconductor structure according to some embodiments of the present disclosure will be described below with reference to FIGS. 5A to 5D.

Referring to FIG. 5A, first, a semiconductor substrate 100 may be etched to form a trench T1 extending along a second horizontal direction Y, and an isolation layer 101 is formed in the trench T1. Then, the semiconductor substrate 100 and the isolation layer 101 are etched by using a patterned hard mask layer 201 as a mask to form a trench T2 extending along a first horizontal direction X, thereby defining an active pillar 110. For example, the depth of the trench T2 is less than the depth of the trench T1.

Next, referring to FIG. 5B, an isolation layer 103 and an isolation layer 105 that are vertically stacked may be formed on a side wall of the trench T2. For example, each of the isolation layer 103 and the isolation layer 105 may be formed by an atomic layer deposition process and an etch-back process. The material of the isolation layer 105 is the same as the material of the isolation layer 101, for example, both may be an oxide (for example, silicon dioxide).

Next, referring to FIG. 5C, the hard mask layer 201 may be removed, and an isolation layer 107 filling the trench T2 is formed. For example, the isolation layer 107 may be formed by a deposition process and a chemical mechanical polishing process/etch-back process. The material of the isolation layer 107 is the same as the material of the isolation layer 103, for example, both may be a nitride (such as silicon nitride).

Next, referring to FIG. 5D, parts of the isolation layer 101 and the isolation layer 105 may be removed by a selective wet etching process, so as to form accommodating grooves 106 in two sides of the active pillar 110 in the first horizontal direction X, the accommodating grooves 106 are configured to accommodate a first gate part 121 of a word line 120 subsequently formed, and the top surface of the remaining isolation layer 101 is lower than the bottom surface of the accommodating grooves 106.

Next, referring to FIGS. 1B to 1E, a gate dielectric layer 130 and a word line 120 may be sequentially formed. For example, the gate dielectric layer 130 may be formed by an atomic layer deposition process and/or a thermal oxidation process. The word line 120 may be formed by an atomic layer deposition process and an etch-back process. For example, the etch-back process may be controlled such that the top surface of the second gate part 122 is higher than the top surface of the first gate part 121 (as shown in FIG. 1D) or the top surface of the second gate part 122 is flush with the top surface of the first gate part 121 (as shown in FIG. 1E).

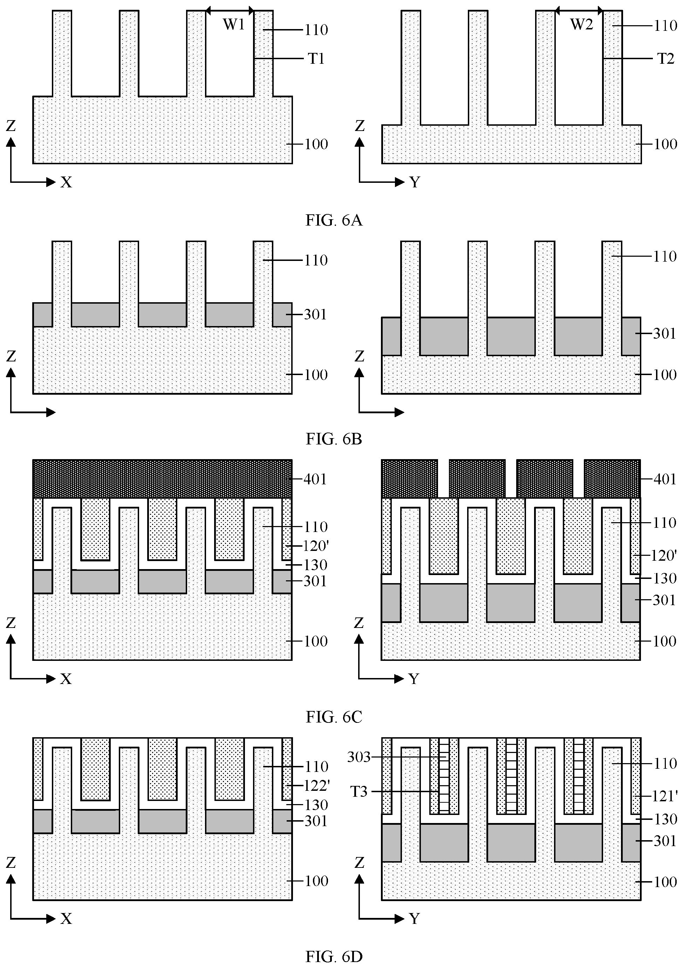

FIGS. 6A to 6D are schematic cross-sectional diagrams of some phases of a method for manufacturing a semiconductor structure according to some other embodiments of the present disclosure. In FIGS. 6A to 6D, the left sub-figure corresponds to a cross-section taken along line A1-A2 in FIG. 1A, and the right sub-figure corresponds to a cross-section taken along line B1-B2 in FIG. 1A. Steps S200 and S300 in the method for manufacturing a semiconductor structure according to some other embodiments of the present disclosure will be described below with reference to FIGS. 6A to 6D.

Referring to FIG. 6A, the semiconductor substrate 100 may be etched to form a trench T3 extending along the second horizontal direction Y and a trench T4 extending along the first horizontal direction X, thereby defining an active pillar 110. For example, the width W1 of the opening of the trench T3 (i.e., the size of the opening of the trench T3 in a horizontal direction perpendicular to the second horizontal direction Y) is less than the width W2 of the opening of the trench T4 (i.e., the size of the opening of the trench T4 in a horizontal direction perpendicular to the first horizontal direction X), such that the trench T3 with smaller depth and the trench T4 with larger depth can be obtained by etching the semiconductor substrate 100 using the etch loading effect. Here, the semiconductor substrate 100 needs to be etched once. In contrast, in the embodiments shown in FIG. 5A, the semiconductor substrate 100 needs to be etched twice.

Next, referring to FIG. 6B, an isolation layer 301 filling the trenches T3 and T4 may be formed, and the top surface of the isolation layer 301 is made flush with the top surface of the active pillar 110 by a chemical mechanical polishing process/etch-back process. Then, the isolation layer 301 is etched back, and based on the etch loading effect, the top surface of a part of the remaining isolation layer 301 located in the trench T3 is higher than the top surface of a part of the remaining isolation layer 301 located in the trench T4. For example, the material of the isolation layer 301 may include an oxide (such as silicon dioxide), a nitride (silicon nitride), an oxynitride (silicon oxynitride), or the like.

Next, referring to FIG. 6C, first, a gate dielectric layer 130 may be formed by an atomic layer deposition process and/or a thermal oxidation process. Then, a word line material layer 120' is formed by a deposition process, and the top surface of the word line material layer 120' is made flush with the top surface of the gate dielectric layer 130 located on the active pillar 110 by a chemical mechanical polishing process/etch-back process. Then, a patterned hard mask layer 401 is formed, and an opening in the patterned hard mask layer 401 exposes a part of the word line material layer 120' in the trench T4.

Next, referring to FIG. 6D, the word line material layer 120' may be etched by using the patterned hard mask layer 401 as a mask, to form grooves T5 for defining initial word lines separated from each other. The initial word line includes a first initial gate part 121' and a second initial gate part 122' that cover a side wall of the active pillar 110 and are connected to each other. Two first initial gate parts 121' are located on two opposite sides of the active pillar 110 in the first horizontal direction X; two second initial gate parts 122' are located on two opposite sides of the active pillar 110 in the second horizontal direction Y. The width of the first initial gate part 121' (i.e., the size of the first initial gate part 121' in the horizontal direction perpendicular to the first horizontal direction X) is less than the width of the second initial gate part 122' (i.e., the size of the second initial gate part 122' in the horizontal direction perpendicular to the second horizontal direction Y), and the bottom surface of the first initial gate part 121' is lower than the bottom surface of the second initial gate part 122'. Then, the patterned hard mask layer 401 is removed, and an isolation layer 303 is formed in the grooves T5. The isolation layer 303 is configured to ensure that adjacent initial word lines are insulated from each other. For example, the isolation layer 303 may be formed by a deposition process and a chemical mechanical polishing process/etch-back process. For example, the material of the isolation layer 303 may include an oxide (such as silicon dioxide), a nitride (silicon nitride), an oxynitride (silicon oxynitride), or the like. For example, in some examples, an air gap (not shown in the figure) may be formed in the isolation layer 303 by controlling the process parameters of the deposition process to reduce the coupling effect between adjacent word lines 120 subsequently formed.

Next, the initial word line may be etched back, and based on the etch loading effect, the top surface of the remaining first initial gate part 121' (i.e., the first gate part 121) may be made higher than the top surface of the remaining second initial gate part 122' (i.e., the second gate part 121), thereby obtaining the word line 120 in the embodiments shown in FIG. 2C.

It should be noted that in the step of etching the semiconductor substrate 100 in FIG. 6A, the width W1 of the opening of the trench T1 may be controlled to be equal to the width W2 of the opening of the trench T2, such that the depth of the trench T1 is equal to the depth of the trench T2. Further, in the step of etching back the isolation layer 301 in FIG. 6B, the top surface of a part of the remaining isolation layer 301 located in the trench T1 is flush with the top surface of a part of the remaining isolation layer 301 located in the trench T2. Therefore, in the subsequently formed word line, the bottom surface of the first gate part 121 is flush with the bottom surface of the second gate part 122, and the top surface of the first gate part 121 is higher than the top surface of the second gate part 122; that is, the word line 120 in the embodiments shown in FIG. 2D can be obtained.

That is, the word line 120 in the embodiments shown in FIGS. 1A and 2A to 2D may be formed by using the etch loading effect.

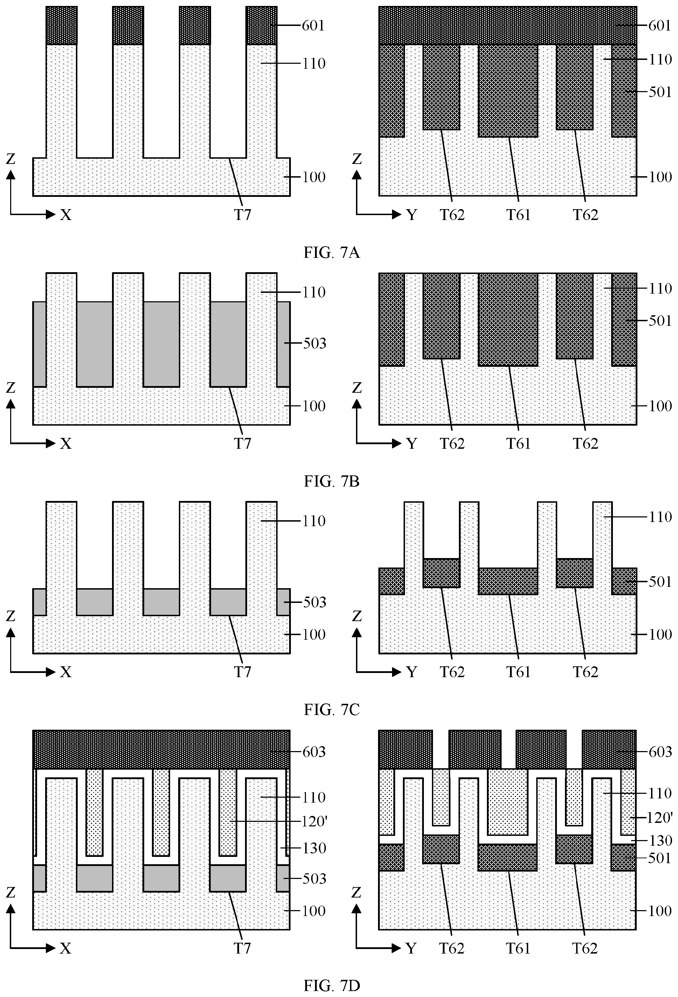

FIGS. 7A to 7E are schematic cross-sectional diagrams of some phases of a method for manufacturing a semiconductor structure according to yet other embodiments of the present disclosure. In FIGS. 7A to 7E, the left sub-figure corresponds to a cross-section taken along line A1-A2 in FIG. 3A, and the right sub-figure corresponds to a cross-section taken along line B1-B2 in FIG. 3A. Steps S200 to S300 in the method for manufacturing a semiconductor structure according to yet other embodiments of the present disclosure will be described below with reference to FIGS. 7A to 7E.

Referring to FIG. 7A, first, the semiconductor substrate 100 may be etched to form trenches T61 and T62 extending along the first horizontal direction X, and an isolation layer 501 filling the trenches T61 and T62 is formed. The trenches T61 and T62 are formed alternately, the width of the opening of the trench T61 is greater than the width of the opening of the trench T62, and based on the etch loading effect, the depth of the trench T61 is greater than the depth of the trench T62. Then, the semiconductor substrate 100 and the isolation layer 501 are etched by using a patterned hard mask layer 601 as a mask to form trenches T7 extending along the second horizontal direction Y, thereby defining an active pillar 110.

Next, referring to FIG. 7B, an isolation layer 503 filling the trench T7 may be formed, and the isolation layer 503 is etched back until the top surface of the remaining isolation layer 503 is lower than the top surface of the isolation layer 501. Then, the patterned hard mask layer 601 is removed. For example, the material of the isolation layer 503 is the same as the material of the isolation layer 501, for example, both may be an oxide (for example, silicon dioxide).

Next, referring to FIG. 7C, the isolation layer 501 and the isolation layer 503 may be etched back synchronously, such that the top surface of the remaining isolation layer 503 is lower than the top surface of a part of the remaining isolation layer 501 located in the trench T61; meanwhile, due to the etch loading effect, the top surface of a part of the remaining isolation layer 501 located in the trench T62 is higher than the top surface of the part of the remaining isolation layer 501 located in the trench T61.

Next, referring to FIG. 7D, first, a gate dielectric layer 130 may be formed by an atomic layer deposition process and/or a thermal oxidation process. Then, a word line material layer 120' is formed by a deposition process, and the top surface of the word line material layer 120' is made flush with the top surface of the gate dielectric layer 130 located on the active pillar 110 by a chemical mechanical polishing process/etch-back process. Then, a patterned hard mask layer 603 is formed, openings in the patterned hard mask layer 603 separately expose a part of the word line material layer 120' in the trench T61 and the word line material layer 120' in the trench T62.

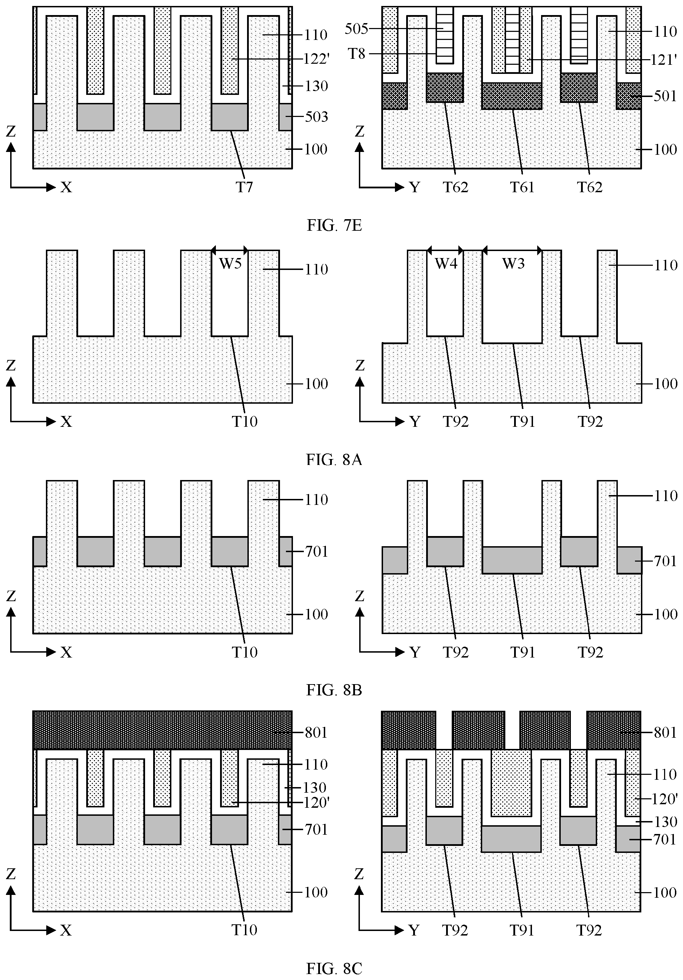

Next, referring to FIG. 7E, the word line material layer 120' may be etched by using the patterned hard mask layer 603 as a mask, to form grooves T8 for defining initial word lines separated from each other. The initial word line includes a first initial gate part 121' and a second initial gate part 122' that cover a side wall of the active pillar 110 and are connected to each other. One first initial gate part 121' is located on one side of the active pillar 110 in the first horizontal direction X; two second initial gate parts 122' are located on two opposite sides of the active pillar 110 in the second horizontal direction Y. The width of the first initial gate part 121' (i.e., the size of the first initial gate part 121' in the horizontal direction perpendicular to the first horizontal direction X) is greater than or equal to the width of the second initial gate part 122' (i.e., the size of the second initial gate part 122' in the horizontal direction perpendicular to the second horizontal direction Y), and the bottom surface of the first initial gate part 121' is higher than the bottom surface of the second initial gate part 122'. Then, the patterned hard mask layer 401 is removed, and an isolation layer 505 is formed in the grooves T8. The isolation layer 505 is configured to ensure that adjacent initial word lines are insulated from each other. For example, the material of the isolation layer 505 may include an oxide (such as silicon dioxide), a nitride (silicon nitride), an oxynitride (silicon oxynitride), or the like. For example, in some examples, an air gap (referring to the air gap AG in FIG. 3C) may be formed in the isolation layer 505 by controlling the process parameters of the deposition process to reduce the coupling effect between adjacent word lines 120 subsequently formed.

Next, the initial word line may be etched back, and based on the etch loading effect, the top surface of the remaining first initial gate part 121' (i.e., the first gate part 121) may be made lower than or flush with the top surface of the remaining second initial gate part 122' (i.e., the second gate part 121), thereby obtaining the word line 120 in the embodiments shown in FIG. 3D or 3E.

FIGS. 8A to 8D are schematic cross-sectional diagrams of some phases of a method for manufacturing a semiconductor structure according to still other embodiments of the present disclosure. In FIGS. 8A to 8D, the left sub-figure corresponds to a cross-section taken along line A1-A2 in FIG. 3A, and the right sub-figure corresponds to a cross-section taken along line B1-B2 in FIG. 3A. Steps S200 to S300 in the method for manufacturing a semiconductor structure according to still other embodiments of the present disclosure will be described below with reference to FIGS. 8A to 8D.

Referring to FIG. 8A, the semiconductor substrate 100 may be etched to form trenches T91 and T92 extending along the first horizontal direction X and a trench T10 extending along the second horizontal direction Y, thereby defining an active pillar 110. For example, the trenches T61 and T62 are formed alternately, and the width W4 of the opening of the trench T92 and the width W5 of the opening of the trench T10 are both less than the width W3 of the opening of the trench T91, such that the trenches T92 and T10 with smaller depth and the trench T91 with larger depth can be obtained by etching the semiconductor substrate 100 using the etch loading effect. Here, the semiconductor substrate 100 needs to be etched once.

Next, referring to FIG. 8B, an isolation layer 701 filling the trenches T91, T92, and T92 may be formed, and the top surface of the isolation layer 701 is made flush with the top surface of the active pillar 110 by a chemical mechanical polishing process/etch-back process. Then, the isolation layer 701 is etched back, and based on the etch loading effect, the top surface of a part of the remaining isolation layer 701 located in the trench T91 is lower than the top surface of parts of the remaining isolation layer 701 located in the trenches T92 and T10. For example, the material of the isolation layer 701 may include an oxide (such as silicon dioxide), a nitride (silicon nitride), an oxynitride (silicon oxynitride), or the like.

Next, referring to FIG. 8C, first, a gate dielectric layer 130 may be formed by an atomic layer deposition process and/or a thermal oxidation process. Then, a word line material layer 120' is formed by a deposition process, and the top surface of the word line material layer 120' is made flush with the top surface of the gate dielectric layer 130 located on the active pillar 110 by a chemical mechanical polishing process/etch-back process. Then, a patterned hard mask layer 801 is formed, and openings in the patterned hard mask layer 801 expose a part of the word line material layer 120' in the trench T91 and the word line material layer 120' in the trench T92.

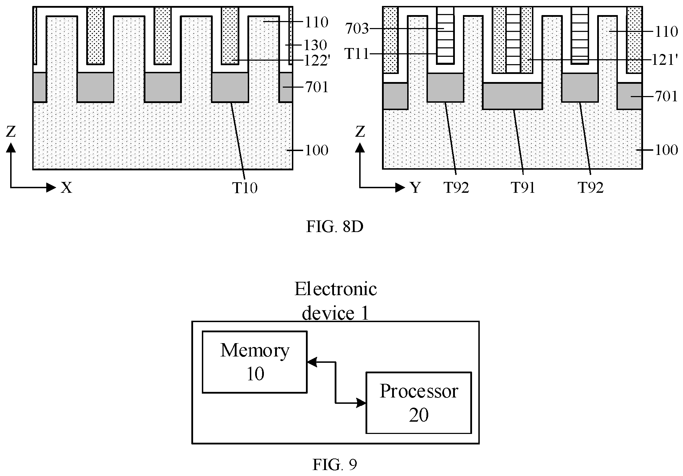

Next, referring to FIG. 8D, the word line material layer 120' may be etched by using the patterned hard mask layer 803 as a mask, to form grooves T11 for defining initial word lines separated from each other. The initial word line includes a first initial gate part 121' and a second initial gate part 122' that cover a side wall of the active pillar 110 and are connected to each other. One first initial gate part 121' is located on one side of the active pillar 110 in the first horizontal direction X; two second initial gate parts 122' are located on two opposite sides of the active pillar 110 in the second horizontal direction Y. The width of the first initial gate part 121' (i.e., the size of the first initial gate part 121' in the horizontal direction perpendicular to the first horizontal direction X) is less than the width of the second initial gate part 122' (i.e., the size of the second initial gate part 122' in the horizontal direction perpendicular to the second horizontal direction Y), and the bottom surface of the first initial gate part 121' is higher than the bottom surface of the second initial gate part 122'. Then, the patterned hard mask layer 801 is removed, and an isolation layer 703 is formed in the grooves T11. The isolation layer 703 is configured to ensure that adjacent initial word lines are insulated from each other. For example, the material of the isolation layer 703 may include an oxide (such as silicon dioxide), a nitride (silicon nitride), an oxynitride (silicon oxynitride), or the like. For example, in some examples, an air gap (referring to the air gap AG in FIG. 4B) may be formed in the isolation layer 703 by controlling the process parameters of the deposition process to reduce the coupling effect between adjacent word lines 120 subsequently formed.

Next, the initial word line may be etched back, and based on the etch loading effect, the top surface of the remaining first initial gate part 121' (i.e., the first gate part 121) may be made higher than the top surface of the remaining second initial gate part 122' (i.e., the second gate part 121), thereby obtaining the word line 120 in the embodiments shown in FIG. 4C.

It should be noted that in the step of etching the semiconductor substrate 100 in FIG. 8A, the width W5 of the opening of the trench T10 may be controlled to be equal to the width W3 of the opening of the trench T91, such that the depth of the trench T10 is equal to the depth of the trench T91. Further, in the step of etching back the isolation layer 701 in FIG. 8B, the top surface of a part of the remaining isolation layer 701 located in the trench T10 is flush with the top surface of a part of the remaining isolation layer 701 located in the trench T91. Therefore, in the subsequently formed word line, the bottom surface of the first gate part 121 is flush with the bottom surface of the second gate part 122, and the top surface of the first gate part 121 is higher than the top surface of the second gate part 122; that is, the word line 120 in the embodiments shown in FIG. 4D can be obtained.

The embodiments of the present disclosure do not limit the method for forming the bit line in step S400, and reference may be made to the methods commonly used in the prior art. For example, in some embodiments, in step S400, the semiconductor substrate 100 may be thinned from the back surface until one end of the active pillar 110 is exposed, and then the bit line 140 is formed.

For example, the above method for manufacturing a semiconductor structure may further include steps of forming a first source/drain region 110a and a second source/drain region 110c in the active pillar 110, forming a data storage element SE, forming a contact pad 115, forming a bit line contact plug 135, or the like. Implementations of these steps may refer to the methods commonly used in the prior art, which are not limited herein.

It should be noted that for details not described in the embodiments of the method for manufacturing a semiconductor structure of the present disclosure, reference can be made to the related description in the foregoing embodiments of the semiconductor structure, and details are not described herein again.

The technical effects and other details of the method for manufacturing a semiconductor structure according to the embodiments of the present disclosure may refer to the related description in the foregoing embodiments of the semiconductor structure, and details are not described herein again.

At least some embodiments of the present disclosure further provide an electronic device. FIG. 9 is a schematic block diagram of a structure of an electronic device according to some embodiments of the present disclosure. As shown in FIG. 9, the electronic device 1 includes a processor 20 and a memory 10 coupled to each other. The memory 10 includes the semiconductor structure according to any one of the foregoing embodiments.

For example, the processor 20 may include, but is not limited to, a central processing unit (CPU), a graphics processing unit (GPU), and the like. The memory 10 may be configured to store data to be processed by the processor 20 and/or data that have been processed by the processor.

For example, the electronic device 1 includes, but is not limited to, a cell phone, a tablet, a smart bracelet, a wearable electronic device, a virtual reality device, an augmented reality device, an in-vehicle device, a server, a workstation, and the like.

The above description is only the specific embodiments of the present disclosure, but the protection scope of the present disclosure is not limited thereto; changes or substitutions that any of those skilled in the art can easily think of within the technical scope disclosed by the present disclosure shall all fall within the protection scope of the present disclosure. Therefore, the protection scope of the present disclosure shall be defined by the protection scope of the claims.

## Claims

1. A semiconductor structure, comprising:
an active pillar (110) extending along a vertical direction (Z);
a word line (120) extending along a first horizontal direction (X) and coupled to the active pillar to form a transistor (TR); and
a bit line (140) extending along a second horizontal direction (Y) and coupled to the active pillar, wherein the second horizontal direction intersects with the first horizontal direction,
wherein the word line comprises a first gate part (121) and a second gate part (122) that cover a side wall of the active pillar and are connected to each other, the first gate part is located on at least one side of the active pillar in the first horizontal direction, the second gate part is located on at least one side of the active pillar in the second horizontal direction, and an average size of the first gate part in the vertical direction is different from an average size of the second gate part in the vertical direction.

2. The semiconductor structure according to claim 1, wherein the active pillar comprises a first source/drain region (110a), a channel region (110b), and a second source/drain region (110c) sequentially arranged in the vertical direction, and the average size of a certain one of the first gate part and the second gate part in the vertical direction is less than a channel length of the channel region in the vertical direction.

3. The semiconductor structure according to claim 2, wherein a maximum size of the certain one of the first gate part and the second gate part in the vertical direction is less than the channel length of the channel region in the vertical direction.

4. The semiconductor structure according to any one of claims 1 to 3, wherein the average size of the first gate part in the vertical direction is less than the average size of the second gate part in the vertical direction.

5. The semiconductor structure according to claim 4, wherein the word line comprises two first gate parts located on two opposite sides of the active pillar in the first horizontal direction and two second gate parts located on two opposite sides of the active pillar in the second horizontal direction.

6. The semiconductor structure according to claim 5, wherein an average size of the first gate part in a horizontal direction perpendicular to the first horizontal direction is less than an average size of the second gate part in a horizontal direction perpendicular to the second horizontal direction.

7. The semiconductor structure according to claim 6, wherein a top surface of the first gate part is lower than or flush with a top surface of the second gate part.

8. The semiconductor structure according to claim 4, wherein the word line comprises one first gate part located on one side of the active pillar in the first horizontal direction and two second gate parts located on two opposite sides of the active pillar in the second horizontal direction.

9. The semiconductor structure according to claim 8, wherein an average size of the first gate part in a horizontal direction perpendicular to the first horizontal direction is greater than an average size of the second gate part in a horizontal direction perpendicular to the second horizontal direction, and a top surface of the first gate part is lower than a top surface of the second gate part.

10. The semiconductor structure according to claim 8, wherein an average size of the first gate part in a horizontal direction perpendicular to the first horizontal direction is equal to an average size of the second gate part in a horizontal direction perpendicular to the second horizontal direction, and a top surface of the first gate part is flush with a top surface of the second gate part.

11. The semiconductor structure according to any one of claims 1 to 3, wherein the average size of the first gate part in the vertical direction is greater than the average size of the second gate part in the vertical direction.

12. The semiconductor structure according to claim 11, wherein the word line comprises two first gate parts located on two opposite sides of the active pillar in the first horizontal direction and two second gate parts located on two opposite sides of the active pillar in the second horizontal direction.

13. The semiconductor structure according to claim 11, wherein the word line comprises one first gate part located on one side of the active pillar in the first horizontal direction and two second gate parts located on two opposite sides of the active pillar in the second horizontal direction.

14. The semiconductor structure according to claim 12 or 13, wherein an average size of the first gate part in a horizontal direction perpendicular to the first horizontal direction is less than an average size of the second gate part in a horizontal direction perpendicular to the second horizontal direction.

15. The semiconductor structure according to claim 14, wherein a bottom surface of the first gate part is lower than or flush with a bottom surface of the second gate part.

16. The semiconductor structure according to any one of claims 1 to 3, further comprising:
a data storage element (SE) coupled to the transistor.

17. A method for manufacturing a semiconductor structure, comprising:
providing a semiconductor substrate (100);
etching the semiconductor substrate to form an active pillar (110) extending along a vertical direction (Z);
forming a word line (120), wherein the word line extends along a first horizontal direction (X) and is coupled to the active pillar; and
forming a bit line (140), wherein the bit line extends along a second horizontal direction (Y) and is coupled to the active pillar, and the second horizontal direction intersects with the first horizontal direction,
wherein the word line comprises a first gate part (121) and a second gate part (122) that cover a side wall of the active pillar and are connected to each other, the first gate part is located on at least one side of the active pillar in the first horizontal direction, the second gate part is located on at least one side of the active pillar in the second horizontal direction, and an average size of the first gate part in the vertical direction is different from an average size of the second gate part in the vertical direction.

18. An electronic device (1), comprising:
a processor (20); and
a memory (10), wherein the memory is coupled to the processor, and the memory comprises the semiconductor structure according to any one of claims 1 to 16.
